# EUROPEAN PATENT APPLICATION

(11) **EP 4 592 697 A1**
(43) Date of publication of application: **30.07.2025**
(21) Application number: 24872779.4
(22) Date of filing: 06.09.2024
(51) Int. Cl.: G01R 31/392, G01R 31/396, G01R 31/389, G06Q 10/08, H01M 10/48, H01M 50/10

(54) **METHOD FOR DETERMINING DEFECT OF BATTERY CELL**

(30) Priority: 25.09.2023 KR 20230127851
(71) Applicant: LG Energy Solution, Ltd., Seoul 07335 (KR)
(72) Inventor: YOON, Hye Rin, Daejeon 34122 (KR)
(74) Representative: Goddar, Heinz J.
(86) International application number: PCT/KR2024/013552
(87) International publication number: WO 2025/071071

(57) **Abstract**

Disclosed is a defective battery cell determination method including a first step of obtaining the resistance values according to temperature of a plurality of battery cells, wherein each battery cell of the plurality of battery cells is of an equal type, a second step of measuring a temperature value and a resistance value of another battery cell, wherein the another battery cell is of the equal type and is not a battery cell of the plurality of battery cells, and a third step of determining whether the measured temperature value and the resistance value of the another battery cell corresponds to a predetermined good quality standard based on data obtained in the first step, wherein it is determined whether the battery cell is defective based on the value measured in the second step without measuring the elapsed time between the first and second steps.

## Description

### [Technical Field]

This application claims the benefit of priority to Korean Patent Application No. 2023-0127851 filed on September 25, 2023, the disclosure of which is incorporated herein by reference in its entirety.

The present invention relates to a defective battery cell determination method. More particularly, the present invention relates to a defective battery cell determination method capable of easily, simply, and accurately determining whether a finished battery cell is defective regardless of the delay time of a logistics line by creating a database having the resistance values of normal battery cells according to temperature.

### [Background Art]

Lithium secondary batteries, which are charged and discharged by the migration of lithium ions, are used not only for small battery cells used in mobile devices and small electronic products due to high energy density and high charging voltage but also for medium and large battery packs used as energy sources for electric vehicles and energy storage systems that require high power and high voltage.

A process of manufacturing a lithium secondary battery includes an electrode process of manufacturing an electrode plate and laminating or winding the electrode plate together with a separator to make an electrode assembly, an assembly process of receiving the electrode assembly in a battery case, injecting an electrolyte into the battery case, and sealing the battery case, and a formation process including a process of charging and discharging a lithium secondary battery thus assembled and aging the lithium secondary battery. During the formation process, defective products may be sorted out and performance may be improved.

In particular, the formation process includes an activation process of charging and discharging the lithium secondary battery such that the finished battery cell has electrical characteristics and a process of determining whether the finished battery cell is defective by measuring the resistance of the battery cell charged for shipment.

Since charging and discharging of the battery cell and the resistance measurement are carried out in separate areas depending on a production environment, charging and discharging of the battery cell and the resistance measurement may not be continuously carried out. In addition, the elapsed time from charging and discharging to the resistance measurement may vary depending on the situation of a logistics line.

Furthermore, in the case of a manual logistics line, the time delay from charging and discharging to the resistance measurement may be longer than that of an automatic logistics line.

During the process of charging and discharging the lithium secondary battery, the temperature of the battery cell increases. Even if the same type of battery cells are charged and discharged under the same conditions, the temperatures of the battery cells after charging and discharging are not constant, and temperature differences between the battery cells may occur.

In addition, a rate of decrease in the temperature of the battery cell varies depending on the time delay from charging and discharging to the resistance measurement. That is, the temperature of the battery cell is a factor that affects the resistance value, and if the time delay from charging and discharging to the resistance measurement is long, the temperature of the battery cell may decrease. As such, if the temperature of the battery cell where the resistance is measured is not uniform, the environment in which the resistance is measured may vary, whereby the reliability of the measured resistance value may be reduced.

In this regard, Patent Document 1 relates to a semiconductor apparatus capable of precisely detecting non-genuine battery cells, wherein the semiconductor apparatus includes a temperature measurement unit configured to measure the temperature of a battery cell, a voltage measurement unit configured to measure the voltage of the battery cell, a current measurement unit configured to measure the current supplied from the battery cell, and a controller. The controller may count the number of charge and discharge cycles of the battery cell, measure the charge ratio of the battery cell based on the voltage, and calculate the internal resistance of the battery cell based on the voltage and the current. That is, in Patent Document 1, it is determined whether the battery cell is a non-genuine product by calculating the internal resistance of the battery cell at the time of shipment by normalizing the internal resistance based on the number of cycles, temperature, and charge ratio.

Patent Document 1 presents an apparatus and method for determining whether a battery cell is a non-genuine product by normalizing the internal resistance based on the number of cycles, temperature, and charge ratio of the battery cell, which, however, is technology for determining whether a commercially available battery cell is a non-genuine product, but does not present a method of accurately determining defective battery cells under the same criterion when a charging and discharging step and a resistance measurement step are carried out in separate areas before shipment of finished battery cells or when there is a certain time interval between the charging and discharging step and the resistance measurement step.

Patent document 2 relates to a method and apparatus for measuring the internal resistance of a battery, wherein the method includes a step of monitoring the voltage and current of the battery in real time, a step of monitoring a rise in voltage, collecting the voltage and current after the current decreases, and storing the collected voltage and current in a data set, and a step of monitoring whether the current has reached a current threshold and determining the internal resistance of the battery using the voltage and current in the data set.

Patent Document 2 presents a method of determining the internal resistance of a battery using the results of measuring the voltage and current of the battery even if the internal resistance of the battery is not measured, but does not present a solution to the problem of the resistance value changing due to the time delay from charging and discharging to the resistance measurement during a formation process of a lithium secondary battery.

Therefore, there is a need for a method of determining whether a battery cell is defective even though a step of charging and discharging the battery cell such that the battery cell has electrical characteristics before shipment of the battery cell and a resistance measurement step of determining whether the battery cell is defective are carried out in separate areas or regardless of the elapsed time from charging and discharging to the resistance measurement.

### (Prior Art Documents)

(Patent Document 1) Japanese Patent Application Publication No. 2019-114437 (2019.07.11)
(Patent Document 2) Chinese Patent Application Publication No. 115902672 (2023.04.04)

### [Disclosure]

### [Technical Problem]

The present invention has been made in view of the above problems, and it is an object of the present invention to provide a defective battery cell determination method capable of accurately determining whether a battery cell is defective regardless of the elapsed time from charging and discharging the battery cell to the resistance measurement for defect determination during a process of manufacturing a lithium secondary battery.

### [Technical Solution]

A defective battery cell determination method according to the present invention to accomplish the above object may include: a first step of obtaining the resistance values according to temperature of a plurality of battery cells, wherein each battery cell of the plurality of battery cells is of an equal type; a second step of measuring a temperature value and a resistance value of another battery cell, wherein the another battery cell is of the equal type and is not a battery cell of the plurality of battery cells; and a third step of determining whether the measured temperature value and the resistance value of the another battery cell corresponds to a predetermined good quality standard based on data obtained in the first step.

The first step may include a 1-1 step of charging and discharging each battery cell of the plurality of battery cells to activate each battery cell of the plurality of battery cells; a 1-2 step of measuring a temperature value of each battery cell of the plurality of battery cells; and a 1-3 step of measuring a resistance value of each battery cell of the plurality of battery cells.

The area where the 1-1 step of charging and discharging each battery cell of the plurality of battery cells is performed may be separated from the area where the 1-2 step of measuring the temperature value of each battery cell of the plurality of battery cells and the 1-3 step of measuring the resistance value of each battery cell of the plurality of battery cells are performed.

The 1-2 step of measuring the temperature value of each battery cell of the plurality of battery cells and the 1-3 step of measuring the resistance value of each battery cell of the plurality of battery cells may be simultaneously performed.

The defective battery cell determination method may further include measuring an elapsed time from the completion of the charging and discharging process to resistance measurement, wherein the elapsed time may be divided and classified into a certain number of intervals, and the resistance values according to the temperature of the plurality of battery cells of the first step may be stored in a database based on the elapsed time.

The charging voltage of the 1-1 step of charging and discharging each battery cell of the plurality of battery cells may be shipment voltage.

The first step to the third step may be applied to a manual logistics line or an automatic logistics line.

The battery cell may be a pouch-shaped battery cell, a cylindrical battery cell, or a prismatic battery cell.

The same type may be based on one or more conditions selected from the group consisting of an appearance of a battery cell, a positive electrode material, a negative electrode material, a separator material, an electrolyte material, an additive, a lot, a charging and discharging condition, and SoC.

The defective battery cell determination method may further include a fourth step of sorting the another battery cell determined to be defective in the third step.

In addition, the present invention may provide various combinations of the above solving means.

### [Advantageous Effects]

As is apparent from the above description, when a defective battery cell determination method according to the present invention is used, it is possible to easily and accurately determine whether a finished battery cell is defective without being affected by the resistance measurement time after charging and discharging for activation of the battery cell.

In addition, even in a manual logistics line where the elapsed time from charging and discharging to the resistance measurement is long, it is possible to quickly determine whether the battery cell is defective by measuring the temperature and resistance values without having to separately measure the elapsed time.

### [Description of Drawings]

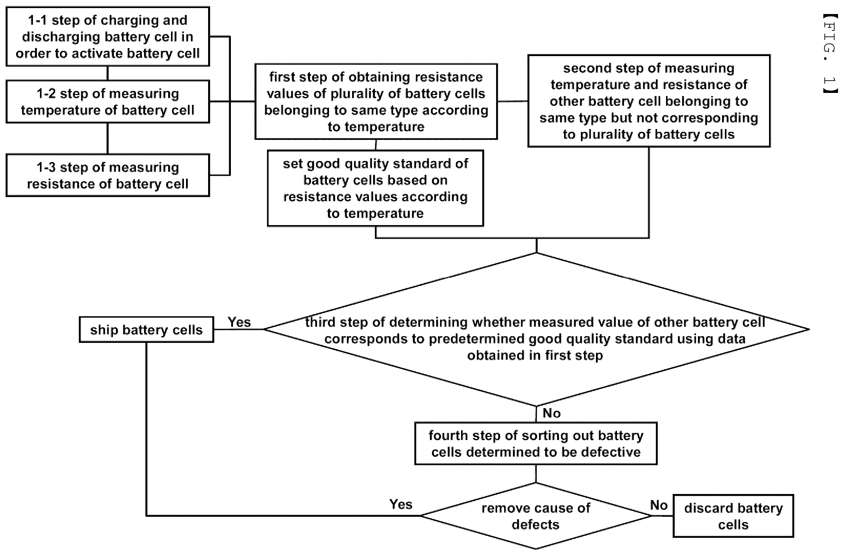

FIG. 1 is a flowchart of a defective battery cell determination method according to the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

The same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that other elements may be further included unless mentioned otherwise.

A description to embody elements through limitation or addition may be applied to all inventions, unless particularly restricted, and does not limit a specific invention.

In the description of the invention and the claims of the present application, singular forms are intended to include plural forms unless mentioned otherwise.

In the description of the invention and the claims of the present application, "or" includes "and" unless mentioned otherwise. Therefore, "including A or B" means three cases, namely, the case including A, the case including B, and the case including A and B.

Embodiments of the present invention will be described in more detail with reference to the drawings.

FIG. 1 is a flowchart of a defective battery cell determination method according to the present invention. Referring to FIG. 1, the defective battery cell determination method according to the present invention may include a first step of obtaining the resistance values of a plurality of battery cells belonging to the same type according to temperature, a second step of measuring the temperature and resistance of another battery cell belonging to the same type but not corresponding to the plurality of battery cells, and a third step of determining whether the measured value of the another battery cell corresponds to a predetermined good quality standard using the data obtained in the first step.

First, in the first step, resistance values according to temperature are obtained for battery cells that are considered to be good and are then stored in a database to set a criterion for determining whether battery cells are good or defective.

Specifically, the first step may include a 1-1 step of charging and discharging a battery cell in order to activate the battery cell, a 1-2 step of measuring the temperature of the battery cell, and a 1-3 step of measuring the resistance of the battery cell.

For example, a battery manufacturing plant may be divided into a battery manufacturing building and a formation building, and a battery manufacturing process may include an electrode process, an assembly process, and a formation process. The electrode process and the assembly process are carried out in the battery manufacturing building, and assembled battery cells may be moved to the formation building, in which a charging and discharging process and a defect determination process may be carried out.

The first step may be carried out at an automatic logistics line in which the battery cells are transferred through a conveyor in the formation building or at a manual logistics line in which the battery cells are transferred by a worker or a robot, and the transfer may be congested depending on the situation of the logistics line.

The 1-1 step, the 1-2 step, and the 1-3 step are carried out in the formation building, and at least one of these steps may be carried out in a separate area. For example, the area where the 1-1 step of charging and discharging the battery cell is carried out may be separated from the area where the 1-2 step of measuring the temperature of the battery cell and the 1-3 step of measuring the resistance of the battery cell are carried out.

That is, the battery cell that has been charged and discharged may be transferred from the charging and discharging area to the resistance measurement area, and resistance of the battery cell may be measured in the resistance measurement area. Depending on the transfer situation of the logistics line, the time from charging and discharging to resistance measurement may differ by more than 300 minutes.

Since the temperature is a factor that affects the resistance value, the 1-2 step of measuring the temperature of the battery cell and the 1-3 step of measuring the resistance of the battery cell must be simultaneously carried out to obtain accurate resistance values according to temperature.

In a specific example, the charging voltage of the 1-1 step of charging and discharging the battery cell may be the shipment voltage. The charging voltage refers to the initial charging voltage when a lithium secondary battery is shipped from a factory after being manufactured in the factory.

In addition, the 1-3 step of measuring the resistance of the battery cell may be carried out according to a direct current internal resistance (DCIR) measurement method. Specifically, the resistance value may be obtained by providing the charge and discharge current values in the form of pulses for a predetermined period of time for each C-rate and converting the resistance value into the voltage and current change values.

Meanwhile, the resistance of the battery cell may be affected by various factors. The battery cell that has increased in temperature during the charging and discharging process starts to cool down when the charging and discharging process is completed. That is, the delay in measuring the resistance after the charging and discharging process is completed may be directly related to the amount of temperature reduction in the battery cell.

In this aspect, the specific heat difference between individual materials constituting the battery cell, such as a positive electrode material, a negative electrode material, a separator material, an electrolyte material, or the kind of an additive, may affect the amount of temperature reduction of the battery cell.

Even if the temperature and resistance of the battery cell that has been charged and discharged are measured in the same area, the resistance measurement may be performed after a certain period of time has elapsed after charging and discharging depending on the working environment.

Therefore, the first step may further include a step of measuring the elapsed time from completion of the activation process to the resistance measurement, wherein the elapsed time may be divided and classified into a certain number of intervals, and the resistance value according to the temperature of the first step may be stored in the database in further consideration of the elapsed time.

Specifically, battery cells with the longest elapsed time may also be included, and the unit for classifying the elapsed time may be set to 1 minute, 5 minutes, etc.

For example, if the unit time is set to one minute, the required time may be classified into one-minute intervals, such as battery cells with a required time of zero to one minute, battery cells with a required time of more than one minute to two minutes, and battery cells with a required time of more than two minutes to three minutes. After classifying the battery cells in this way, the temperature and resistance of all the battery cells are measured, recorded, and stored in the database.

The criterion for determining good products and defective products may be set based on data stored in the database, as needed.

In addition, the electrical characteristics of battery cells may vary depending on a charging and discharging condition such as current and voltage in the 1-1 step and the SoC value, and the electrical characteristics of the battery cells may also vary for each lot, which is a line that produces the battery cells.

As the same type defined in the first step, therefore, it is preferable for one or more conditions selected from the group consisting of the kind of the battery cell, which is the appearance of the battery cell, such as a pouch-shaped battery cell, a cylindrical battery cell, or a prismatic battery cell, a positive electrode material, a negative electrode material, a separator material, an electrolyte material, the kind of an additive, a lot, a charging and discharging condition, and SoC to be the same, it is more preferable for two or more conditions to be the same, and it is most preferable for all of the conditions to be the same.

The second step is a step of measuring the temperature and resistance of a new battery cell, which needs to be classified as defective or not, in other words, a battery cell to be shipped. Of course, it should be understood that the battery cell should be the same type as the battery cells in the first step.

In the third step, the temperature and resistance of the new battery cell may be compared with the criterion set according to the database obtained in the first step to determine whether the battery cell is good or defective.

The temperature and resistance of the battery cell measured in the second step may be compared with the criterion for good and defective products according to the data stored in the database to determine whether the battery cell is good or defective.

As such, in the present invention, the resistance of a plurality of battery cells according to temperature is measured in advance, and additionally, the elapsed time from charging and discharging to resistance measurement is reflected in the resistance value according to the temperature and stored in a database to set a defect determination criterion. Therefore, it is possible to determine whether a new battery cell is defective simply by matching the temperature and resistance values of the new battery cell to the database.

Therefore, it is possible to determine whether a new battery cell is defective in a simple way by matching the temperature and resistance values of the new battery cell to the predetermined defect determination criterion without having to consider the elapsed time from charging and discharging to resistance measurement or the measurement space.

Meanwhile, due to the characteristics of the manual logistics line, the elapsed time from charging and discharging to resistance measurement is longer or more variable than that of the automated logistics line. As described above, the longer the elapsed time, the greater the temperature change in which the battery cell is cooled. Therefore, the elapsed time must be taken into account to increase the reliability of the measured resistance value.

In the present invention, the resistance value according to the temperature is stored in the database in consideration of the elapsed time, and therefore the defective battery cell determination method including the first step to the third step may be applied to both the manual logistics line and the automatic logistics line. Therefore, even when the manual logistics line with low reliability for the resistance value is used, it is possible to quickly and accurately determine whether the battery cell is defective according to the present invention.

Meanwhile, the defective battery cell determination method may further include a fourth step of sorting out the battery cells determined to be defective in the third step, wherein defective battery cells from which the cause of defects can be removed are transferred to the shipping process after removing the cause of defects, and defective battery cells from which the cause of defects cannot be removed are discarded. Of course, the battery cells that are determined to be good in the third step are transferred to the shipping process.

In the present invention, the battery cell includes a pouch-shaped battery cell having an electrode assembly received in a pouch-shaped battery case made of a laminate sheet, a cylindrical battery cell manufactured by inserting an electrode assembly into a cylindrical can made of a metal material and sealing the cylindrical can, or a prismatic battery cell manufactured by inserting an electrode assembly into a prismatic can made of a metal material and sealing the prismatic can. The pouch-shaped battery cell, the cylindrical battery cell, or the prismatic battery cell is known, and therefore a detailed description thereof will be omitted in this specification.

Those skilled in the art to which the present invention pertains will appreciate that various applications and modifications are possible within the scope of the present invention based on the above description.

## Claims

1. A defective battery cell determination method comprising:
a first step of obtaining resistance values according to temperature of a plurality of battery cells, wherein each battery cell of the plurality of battery cells is of an equal type;
a second step of measuring a temperature value and a resistance value of another battery cell, wherein the another battery cell is of the equal type and is not a battery cell of the plurality of battery cells; and
a third step of determining whether the measured temperature value and the resistance value of the another battery cell correspond to a predetermined good quality standard based on data obtained in the first step.

2. The defective battery cell determination method according to claim 1, wherein the first step comprises:
a 1-1 step of charging and discharging each battery cell of the plurality of battery cells to activate each battery cell of the plurality of battery cells;
a 1-2 step of measuring a temperature value of each battery cell of the plurality of battery cells; and
a 1-3 step of measuring a resistance value of each battery cell of the plurality of battery cells.

3. The defective battery cell determination method according to claim 2, wherein an area where the 1-1 step of charging and discharging each battery cell of the plurality of battery cells is performed is separated from an area where the 1-2 step of measuring the temperature value of each battery cell of the plurality of battery cells and the 1-3 step of measuring the resistance value of each battery cell of the plurality of battery cells are performed.

4. The defective battery cell determination method according to claim 2, wherein the 1-2 step of measuring the temperature value of each battery cell of the plurality of battery cells and the 1-3 step of measuring the resistance value of each battery cell of the plurality of battery cells are simultaneously performed.

5. The defective battery cell determination method according to claim 2, further comprising:
measuring an elapsed time from completion of the charging and discharging process to resistance measurement, wherein
the elapsed time is divided and classified into a certain number of intervals, and
the resistance values according to the temperature of the plurality of battery cells of the first step is stored in a database based on the elapsed time.

6. The defective battery cell determination method according to claim 2, wherein charging voltage of the 1-1 step of charging and discharging each battery cell of the plurality of battery cells is shipment voltage.

7. The defective battery cell determination method according to claim 1, wherein the first step to the third step are applied to a manual logistics line or an automatic logistics line.

8. The defective battery cell determination method according to claim 1, wherein the battery cell is a pouch-shaped battery cell, a cylindrical battery cell, or a prismatic battery cell.

9. The defective battery cell determination method according to claim 1, wherein, the equal type is based on one or more conditions selected from a group consisting of an appearance of a battery cell, a positive electrode material, a negative electrode material, a separator material, an electrolyte material, an additive, a lot, a charging and discharging condition, and SoC.

10. The defective battery cell determination method according to claim 1, further comprising a fourth step of sorting the another battery cell determined to be defective in the third step.
